(19) Europäisches Patentamt
European Patent Office
Office européen des brevets

(11) **EP 2 599 216 B1**

(12) **EUROPÄISCHE PATENTSCHRIFT**

(45) Veröffentlichungstag und Bekanntmachung des Hinweises auf die Patenterteilung:
**17.04.2019 Patentblatt 2019/16**

(21) Anmeldenummer: **11748563.1**

(22) Anmeldetag: **18.07.2011**

(51) Int Cl.:
**H03B 5/12** *(2006.01)*

(86) Internationale Anmeldenummer:
**PCT/EP2011/003584**

(87) Internationale Veröffentlichungsnummer:
**WO 2012/013308 (02.02.2012 Gazette 2012/05)**

(54) **SCHALTUNGSANORDNUNG MIT KOMPENSATIONSKAPAZITÄTEN ZUR ERZEUGUNG VON MIKROWELLEN-SCHWINGUNGEN**

CIRCUIT ARRANGEMENT WITH COMPENSATION CAPACITANCES FOR PRODUCING MICROWAVE OSCILLATIONS

CIRCUITERIE DOTÉE DE CAPACITÉS DE COMPENSATION POUR GÉNÉRER DES OSCILLATIONS HYPERFRÉQUENCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.07.2010 DE 102010032574**

(43) Veröffentlichungstag der Anmeldung:
**05.06.2013 Patentblatt 2013/23**

(73) Patentinhaber: **KROHNE MESSTECHNIK GMBH & CO. KG**
**47058 Duisburg (DE)**

(72) Erfinder: **POHL, Nils**
**44801 Bochum (DE)**

(74) Vertreter: **Gesthuysen, Hans Dieter**
**Gesthuysen, von Rohr & Eggert**
**Huyssenallee 100**
**45128 Essen (DE)**

(56) Entgegenhaltungen:
WO-A1-2009/156793    DE-A1-102008 061 254
US-A1- 2003 042 989    US-A1- 2005 174 184

• NICOLSON S T ET AL: "Design and Scaling of W-Band SiGe BiCMOS VCOs", IEEE JOURNAL OF SOLID-STATE CIRCUITS, IEEE SERVICE CENTER, PISCATAWAY, NJ, USA, vol. 42, no. 9, 1 September 2007 (2007-09-01), pages 1821-1833, XP011191285, ISSN: 0018-9200, DOI: 10.1109/JSSC.2007.900769

**Beschreibung**

Die Erfindung betrifft ein Verfahren zur Bestimmung von Kapazitätswerten für Kompensations-Kapazitäten in einer Schaltungsanordnung gemäß Anspruch 1, die aus der deutschen Offenlegungsschrift 10 2008 061 254 bekannt ist.

Die Erzeugung von Mikrowellen-Schwingungen, also von hochfrequenten bis höchstfrequenten elektrischen Schwingungen, beispielsweise bis etwa 80 GHz oder gar bis 100 GHz, ist Kern vieler verschiedener Anwendungen. So benötigen z. B. Radar-Systeme zur Messung von Abständen und zur Messung von Geschwindigkeiten hochstabile Mikrowellen-Schwingungen. Aber auch für andere Meßgeräte und für Kommunikationsanwendungen werden solche Mikrowellen-Schwingungen benötigt.

Zur Erzeugung von Mikrowellen-Schwingungen wird in der Regel eine Oszillator-Schaltung verwendet, die entweder als monolithisch integrierte Schaltung auf einem Chip oder als hybride Schaltung auf einer Platine realisiert werden kann. Gemäß der Barkhausen-Formel weisen diese Oszillator-Schaltungen - wie alle Oszillator-Schaltungen - mindestens ein Verstärker-Element auf, und zwar - seit Jahrzehnten - ein Halbleiter-Bauelement als Verstärker-Bauelement. Insbesondere kann es sich bei dem Verstärker-Element um einen Transistor - welcher Art auch immer - handeln. Zu den Oszillator-Schaltungen gehört des weiteren - wiederum wie zu allen Oszillator-Schaltungen - ein Resonator, der die Frequenz der Oszillator-Schaltung bestimmt. Für Oszillator-Schaltungen, bei denen die Frequenz der Mikrowellen-Schwingung einstellbar sein soll, wird mindestens eine verstimmbare Impedanz benötigt. Häufig wird als verstimmbare Impedanz eine verstimmbare Kapazität, ein Varaktor, verwendet. Durch ein Verändern der Steuerspannung am Varaktor ändert sich die relevante Kapazität und damit auch die Frequenz der Oszillator-Schaltung. Im Idealfall wird die Frequenz der Oszillator-Schaltung nur über die Steuerspannung am Varaktor verändert und hängt die Frequenz der Oszillator-Schaltung nicht von weiteren Faktoren ab. In der Realität beeinflussen jedoch weitere Faktoren das Verhalten der Oszillator-Schaltung, insbesondere die Frequenz der Oszillator-Schaltung, wie etwa die Versorgungsspannung der Oszillator-Schaltung, die vorliegende Temperatur oder die äußere Last an der Oszillator-Schaltung. Teilweise kann diese Beeinflussung durch eine Phasenregelung kompensiert werden. Allerdings kann gerade die Beeinflussung durch die äußere Last an der Oszillator-Schaltung, die Lastrückwirkung, nicht durch eine Phasenregelung kompensiert werden.

Eine ungenügende Entkopplung der Oszillator-Schaltung von der äußeren Last führt dazu, daß die äußere Last, die beispielsweise eine längere Anschlußleitung sein kann, für die Oszillator-Schaltung zusätzlich als Resonator wirkt. Dieser parasitäre Resonator kann in vielen Fällen eine deutlich bessere Güte aufweisen als der eigentliche Resonator der Oszillator-Schaltung. Allerdings wirkt diese Verbesserung der Güte nur bei bestimmten Frequenzen, bei anderen Frequenzen wird die gesamte Güte der Oszillator-Schaltung durch den externen Resonator erheblich verschlechtert. Folglich tritt eine Modulation des Phasenrauschens über der Frequenz der Oszillator-Schaltung auf. In Extremfällen kann die Abstimmkennlinie der Frequenz der Oszillator-Schaltung über die Steuerspannung Sprünge aufweisen. Es kann also eine geringe Änderung der Steuerspannung bereits zu einem plötzlichen Sprung der Frequenz der Oszillator-Schaltung führen. Dies kann so weit gehen, daß die Tuning-Kennlinie nicht eindeutig ist, so dass das Abstimmen in verschiedene Richtungen zu einer Hysterese in der Tuning-Kennlinie führt. Als Folge kann die Oszillator-Schaltung nicht mehr lückenlos abgestimmt werden. Außerdem kann ein plötzliches Umschalten der Last, beispielsweise durch Umschalten zwischen verschiedenen Antennen, die Oszillator-Schaltung verstimmen. Aber selbst in Oszillator-Schaltungen mit Phasenregelung können sowohl diese Sprünge als auch stellenweise zu starkes Phasenrauschen dazu führen, daß die Phasenregelung die Oszillator-Schaltung nicht mehr stabilisieren kann, so dass die gesamte Schaltungsanordnung nicht mehr funktionstüchtig ist. Um diesen Effekt, der in der Fachliteratur meist als "Load-Pulling" bezeichnet wird, zu verhindern, ist eine stärkere Entkopplung der Oszillator-Schaltung von seiner äußeren Last nötig. Insoweit gibt es drei Arten von Lösungsansätzen, die oft kombiniert zum Einsatz kommen:

Der erste Lösungsansatz ist eine passive reziproke Entkopplung. Hierbei wird zwischen der Last und der Oszillator-Schaltung ein passives reziprokes Entkopplungsnetzwerk geschaltet. Dieses kann beispielsweise durch ein Dämpfungsglied, durch einen Spannungsteiler oder durch einen einfachen, in Reihe oder parallel zur Last geschalteten Widerstand realisiert werden. Eine passive Entkopplung bewirkt immer auch eine Reduzierung der verfügbaren Ausgangsleistung der Oszillator-Schaltung, da die Rückwärtsisolation des passiven reziproken Entkopplungsnetzwerks immer identisch der Dämpfung des Ausgangssignals der Oszillator-Schaltung ist.

Ein zweiter Lösungsansatz ist eine passive nicht-reziproke Entkopplung. Hierbei werden wiederum passive Entkopplungsnetzwerke verwendet, nunmehr aber mit nicht-reziproken Komponenten wie Isolatoren, Zirkulatoren oder Ferriten. Mit diesen Komponenten ist es möglich, eine Rückwärtsisolation zu erzielen, die deutlich größer sein kann als die Dämpfung des Ausgangssignals der Oszillator-Schaltung. Die Ausgangsleistung der Oszillator-Schaltung bleibt somit im wesentlichen erhalten. Allerdings lassen sich nicht-reziproke Komponenten nur mit einem erheblichen Aufwand realisieren. Eine Integration auf einem Chip ist mit vertretbarem Aufwand nicht möglich, eine Integration auf einer Platine ist mit hohen Kosten verbunden.

Der dritte Lösungsansatz ist die aktive Entkopplung. Hierbei wird zwischen der Last und der Oszillatorschaltung eine aktive Schaltung aus HalbleiterBauelementen, z. B. Transistoren, geschaltet. Meist wirkt diese Schaltung sogar noch als Verstärker; deswegen spricht man häufig auch von einem Trennverstärker. Diese Schaltungen können eine sehr große Rückwärtsisolation erreichen, ohne das Ausgangssignal der Oszillator-Schaltung zu dämpfen. Allerdings wird zum Betrieb einer aktiven Entkopplung prinzipbedingt zusätzliche Leistung benötigt, die dann die Verlustleistung insgesamt erhöht. In vielen Anwendungen übersteigt die Leistungsaufnahme des Trennverstärkers die der eigentlichen Oszillator-Schaltung, da zur guten Entkopplung der Trennverstärker mehrstufig ausgeführt wird.

Wie eingangs ausgeführt, betrifft die Erfindung eine Schaltungsanordnung zur Erzeugung von Mikrowellen-Schwingungen, mit einem Oszillator mit zwei Transistoren als Verstärker-Elemente und mit einem Resonator, wobei der Resonator vorzugsweise ein Basis-Impedanznetzwerk und zwei Emitter-Impedanznetzwerke aufweist und wobei das Basis-Impedanznetzwerk oder/und ein Emitter-Impedanznetzwerk oder beide Emitter-Impedanznetzwerke verstimmbar ist bzw. sind.

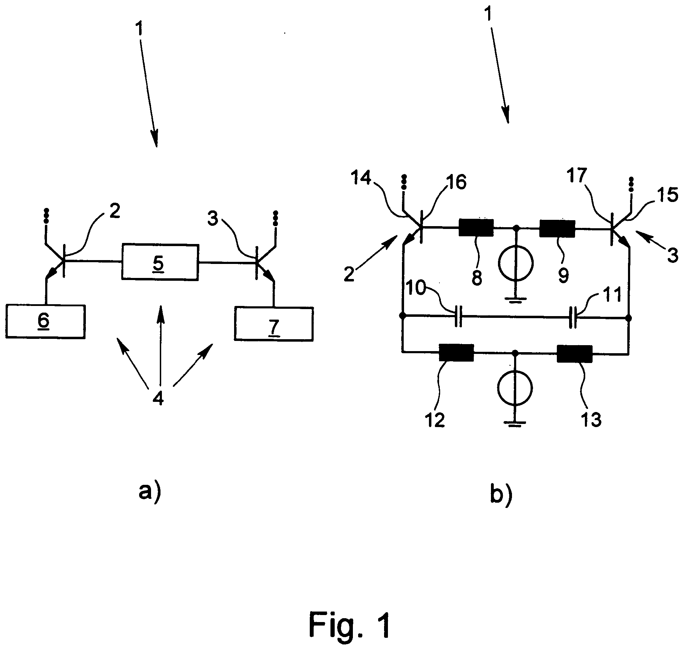

Zur Realisierung von Oszillator-Schaltungen im Millimeter-Wellenbereich werden häufig monolithisch integrierte Schaltungen verwendet. In diesen Schaltungen wird meist eine komplett symmetrische Struktur gewählt. Man spricht von einem differentiellen Schaltungskonzept. Dieser Stand der Technik wird nachfolgend in Verbindung mit der Fig. 1 erläutert; dabei zeigt die Fig. 1 a) das Prinzip, die Fig. 1 b) eine typische Realisierung.

Die Fig. 1 zeigt eine zu einer Schaltungsanordnung zur Erzeugung von Mikrowellen-Schwingungen gehörende Oszillator-Schaltung 1 mit zwei Verstärker-Elementen, nämlich mit zwei Transistoren 2 und 3, und mit einem Resonator 4. Bei der Oszillator-Schaltung 1, die in der Fig. 1 dargestellt ist, weist der Resonator 4 ein Basis-Impedanznetzwerk 5 und zwei Emitter-Impedanznetzwerke 6, 7 auf. Nicht dargestellt ist, daß das Basis-Impedanznetzwerk 5, ein Emitter-Impedanznetzwerk 6 oder 7, beide Emitter-Impedanznetzwerke 6 und 7 oder das Basis-Impedanznetzwerk 5 und die Emitter-Impedanznetzwerke 6 und 7 verstimmbar ist bzw. sind. Das Basis-Impedanznetzwerk 5 und die Emitter-Impedanznetzwerke 6 und 7 bestimmen nicht nur die Frequenz der Oszillator-Schaltung 1, sie bestimmen vielmehr auch die Arbeitspunkteinstellung der Transistoren 2 und 3. Das Basis-Impedanznetzwerk 5 und die Emitter-Impedanznetzwerke 6 und 7 müssen nicht getrennt realisiert sein, auch eine Verkopplung ist möglich. Um die Schwingbedingung zu erfüllen, sollte das Basis-Impedanznetzwerk 5 primär induktiv und sollten die Emitter-Impedanznetzwerke 6 und 7 primär kapazitiv wirken. Über die Emitter-Impedanznetzwerke 6 und 7 muß ein Strom in die Transistoren 2 und 3 eingespeist werden. Wenn so die Schwingbedingung erfüllt ist, sorgt dies für eine Gegentaktoszillation, die Transistoren 2 und 3 arbeiten also genau um eine halbe Periode verschoben.

Bei der in der Fig. 1 b) gezeigten Realisierung der in der Fig. 1 a) als Prinzip dargestellten Oszillator-Schaltung 1 besteht das Basis-Impedanznetzwerk 5 aus zwei Induktivitäten 8 und 9, während die beiden Emitter-Impedanznetzwerke 6 und 7 aus zwei Kapazitäten 10 und 11 und aus zwei Induktivitäten 12 und 13 bestehen. Die Induktivitäten 12 und 13 sind sehr groß und dienen vorwiegend zum Einspeisen des Stromes in die Transistoren 2 und 3.

In dem in der Fig. 1 dargestellten Ausführungsbeispiel einer zu einer Schaltungsanordnung zur Erzeugung von Mikrowellen-Schwingungen gehörenden Oszillator-Schaltung 1, Fig. 1 a) prinzipielle Darstellung, Fig. 1 b) typische Realisierung, wird das Ausgangssignal der Oszillator-Schaltung 1 über die Kollektoren 14, 15 der Transistoren 2, 3 ausgekoppelt und typischerweise über ein nicht dargestelltes Anpaßnetzwerk und einen nicht dargestellten Ausgangsbuffer zur ebenfalls nicht dargestellten Last geführt. Diese Auskopplung über die Kollektoren 14, 15 der Transistoren 2, 3 bewirkt im idealisierten Fall eine sehr gute Entkopplung. Allerdings weisen die Transistoren 2, 3 jeweils eine nicht dargestellte parasitäre Basis-Kollektor-Kapazität auf. Die parasitären Basis-Kollektor-Kapazitäten bewirken gerade bei hohen Frequenzen eine starke Rückwirkung der Last auf die Oszillator-Schaltung 1.

Ausgehend von dem zuvor im einzelnen beschriebenen Stand der Technik hat man sich bereits bemüht, die beschriebene nachteilige Rückwirkung der Last auf die Oszillator-Schaltung und damit auf die Schaltungsanordnung zur Erzeugung von Mikrowellen-Schwingungen, zu der die Oszillator-Schaltung gehört, zu reduzieren bzw., soweit als möglich, zu eliminieren, und zwar dadurch, dass zwischen dem Kollektor des ersten Transistors und der Basis des zweiten Transistors sowie zwischen dem Kollektor des zweiten Transistors und der Basis des ersten Transistors jeweils eine Kompensations-Kapazität geschaltet ist und die Kompensations-Kapazitäten etwa so groß sind wie die parasitären Basis-Kollektor-Kapazitäten (vergleiche dazu die deutsche Offenlegungsschrift 10 2008 061 254). Dadurch wird bewirkt, daß ein Signal, welches von der Last in die Oszillator-Schaltung eingekoppelt wird, weitestgehend ausgelöscht wird. Das Signal, welches von der Last in die Oszillator-Schaltung eingekoppelt wird, wird auf beiden Seiten gleichphasig eingekoppelt. Da die Oszillator-Schaltung im Gegentakt schwingt, taucht das von der gentakt schwingt, taucht das von der Last in die Oszillator-Schaltung eingekoppelte Signal im differenziellen Signal, also im Ausgangssignal nicht auf. Die grundsätzliche Möglichkeit der Kompensation des Einflusses von Basis-Kollektor-Kapazitäten ist auch bereits in der Literatur beschrieben (Aufsatz "Design and Scaling of W-Band SiGe BiCMOS VCOs" von S. Nicolson et al. in der Literaturstelle "IEEE Journal of Solid-State Circuits", vol. 42, No. 9, September 2007). Diese Kompensation wird im Stand der Technik auch verwendet, um den Miller-Effekt zu kompensieren und damit die Frequenz einer Oszillator-Schaltung zu erhöhen (vgl. dazu die Seiten 316 und 317 in dem Standard-Werk "Halbleiter-Schaltungstechnik" von Dr.-Ing. Ulrich Tietze und Dr. Christoph Schenk, 12. Auflage, Springer-Verlag, und den Aufsatz "Dependence of the input impedance of a three-electrode vacuum tube upon the load in the plate cirsuit" in der Literaturstelle "Scientific Papers of the Bureau of Standards" 15(351):367-385, 1920). Ein Miller-Effekt tritt allerdings nur auf, wenn zwischen dem Basis-Knoten und dem Kollektor-Knoten eines Transistors eine Spannungsverstärkung auftritt, was bei vielen Dimensionierungen nicht der Fall ist.

Durch die beschriebene verringerte Rückwirkung der Last auf die Oszillator-Schaltung, nachfolgend auch kurz mit Lastrückwirkung bezeichnet, ist es möglich, im Vergleich zu anderen Schaltungskonzepten (vgl. den Aufsatz "Fully Integrated SiGe VCOs With Powerful Output Buffer for 77-GHz Automotive Radar Systems and Applications Around 100 GHz" in der Literaturstelle "IEEE Journal of solid-state circuits", vol. 39, No. 10, October 2004) den Ausgangsbuffer erheblich zu vereinfachen und die benötigte Verlustleistung zu reduzieren, wodurch unter anderem der Aufwand für die Wärmeableitung deutlich verringert und die Zuverlässigkeit der Oszillator-Schaltung - und damit der erfindungsgemäßen Schaltungsanordnung zur Erzeugung von Mikrowellen-Schwingungen - erhöht werden kann. Gerade in batteriebetriebenen Schaltungsanordnungen ist die zur Verfügung stehende Leistung beschränkt, so dass sich insbesondere dort die Verringerung der benötigten Verlustleistung sehr positiv auswirkt.

Die beschriebene Reduzierung der Lastrückwirkung verringert bei einer typischen Realisierung der Rückwärtsisolation die Lastrückwirkung, wie eingangs ausgeführt auch mit "Load-Pulling" bezeichnet, um den Faktor 5 bis 10. Dem Stand der Technik, von dem die Erfindung ausgeht, zum Beispiel der in der Patentschrift DE 102008061254 veröffentlichten Oszillatorschaltung, kann nicht entnommen werden, wie die Kompensations-Kapazitäten im einzelnen realisiert werden können, so dass es zunächst eine Aufgabe der Erfindung ist, insoweit eine Lösung anzugeben.

Die parasitäre Basis-Kollektor-Kapazität von Transistoren wird durch zwei Effekte verursacht. Erstens bewirkt der gesperrte pn-Übergang zwischen der Basis und dem Kollektor eine Sperrschichtkapazität, welche von der Temperatur und der Sperrspannung abhängt. Zweitens wirkt zwischen den Zuleitungen zu der Basis und dem Kollektor eine konstante Kapazität.

Im einfachsten Fall kann die Kompensations-Kapazität als konstante Kapazität zwischen zwei Metall-Elektroden realisiert werden. Dies kann in einer integrierten Schaltung entweder in horizontaler Ausrichtung zwischen zwei Metall-Platten erfolgen (bezeichnet als Metall-Isolator-Metall = MIM), oder es wird - meist in sehr fein strukturierten Prozessen - die Kapazität zwischen zwei Metall-Leitungen in derselben Ebene in vertikaler Richtung ausgenutzt (bezeichnet als Vertical-Parallel-Plate = VPP). Diese beiden Ansätze führen zu einer Kompensations-Kapazität hoher Güte.

Erfindungsgemäß werden nun zunächst die Kompensations-Kapazitäten durch gesperrte pn-Übergänge realisiert.

Für die Kapazität $C_{sp}$ eines gesperrten pn-Übergangs gilt:

$$C_{sp} = \frac{C_{sp,0}}{\left(1 + \frac{U_{sp}}{U_D}\right)^m}$$

Hierbei ist $U_{sp}$ die Sperrspannung am pn-Übergang, m eine Konstante (abhängig vom Dotierungsprofil, etwa 0,5, $C_{sp,0}$ wiederum eine Konstante (abhängig von der Fläche und der Dotierung des pn-Übergangs) und

$$U_D = \frac{k \cdot T}{e} ln\left(\frac{N_D N_A}{n_i^2}\right)$$

mit k und e als Naturkonstanten, T der Temperatur am pn-Übergang, $N_A$ und $N_D$ Dotierstoffkonzentrationen und $n_i$ der intrinsischen Dichte. Hiermit ergibt sich eine Kompensations-Kapazität, welche einerseits vom Arbeitspunkt, Sperrspannung $U_{sp}$ und der Temperatur T, andererseits von Technologie- und Geometriegrößen abhängt. Da die Bahngebiete des Halbleiters zusätzlich ohmsche Verluste aufweisen, ergibt sich in der Regel eine Kompensations-Kapazität geringerer Güte als bei einer metallischen Kompensations-Kapazität, wie sie weiter oben beschrieben ist. Es hat sich jedoch gezeigt, dass die Güte der durch gesperrte pn-Übergänge realisierten Kompensations-Kapazitäten hinreichend groß ist.

Ein besonders bevorzugtes Ausführungsbeispiel der erfindungsgemäßen Realisierung der Kompensations-Kapazitäten ist dadurch gekennzeichnet, dass die - als Kompensations-Kapazitäten vorgesehenen - gesperrten pn-Übergänge in gleicher Weise wie die parasitären Basis-Kollektor-Kapazitäten der zu der Oszillator-Schaltung gehörenden Transistoren realisiert werden. Das hat verschiedene Vorteile:

Zunächst sind beide Kapazitäten, also sowohl die Kompensations-Kapazitäten als auch die parasitären Basis-Kollektor-Kapazitäten der Transistoren, eine identische Kompensation aus Sperrschichtkapazität und konstanter Verdrahtungskapazität. Des Weiteren ergeben sich durch die identische Realisierung - auch bei Prozessschwankungen von Dotierstoffkonzentrationen und geometrischen Ausdehnungen - identische Kapazitäten, da beide Kapazitäten überwiegend identisch beeinflusst werden (bezeichnet mit Matching). Schließlich wirken Schwankungen der Temperatur und des Arbeitspunktes auf beide pn-Übergänge identisch, so dass beide Kapazitäten stets identisch bleiben.

Die identische Realisierung der Kompensations-Kapazitäten und der parasitären Basis-Kollektor-Kapazitäten der Transistoren kann dadurch erreicht werden, dass als die Kompensations-Kapazitäten realisierenden pn-Übergänge die pn-Übergänge von Transistoren verwirklicht sind, die mit den zu der Oszillator-Schaltung gehörenden Transistoren identisch sind. Dabei kann dann jeder Emitter der Transistoren, deren pn-Übergänge die Kompensations-Kapazitäten realisieren, mit dessen Basis kurzgeschlossen sein.

Mit dem, was zuvor beschrieben worden ist, lassen sich Kompensations-Kapazitäten realisieren, die unabhängig von äußeren Schwankungen funktionieren, was mit konstanten Kompensations-Kapazitäten nicht möglich ist.

In der Umsetzung der erfindungsgemäßen Schaltungsanordnung muss, insbesondere beim Einsatz zur Erzeugung von sehr hochfrequenten Mikrowellen-Schwingungen, auf besonders kurze Leitungslängen zwischen den zu der Oszillator-Schaltung gehörenden Transistoren und den die Kompensations-Kapazitäten realisierenden pn-Übergängen geachtet werden. Doch auch dann, wenn bei der Umsetzung ein extrem kompaktes Layout angestrebt wird, ergibt sich durch die notwendige Verdrahtung eine parasitäre Serieninduktivität. Durch diese zusätzliche parasitäre Serieninduktivität ergibt sich, unterhalb der Resonanzfrequenz des Serienschwingkreises, eine kapazitive Wirkung mit einer vergrößerten effektiven Kapazität $C_{m, \text{eff}}$, für die gilt:

$$C_{M,\text{eff}} = \frac{C_M}{1 - \omega^2 \cdot C_M \cdot L_{par}}$$

mit $C_m$ Kompensations-Kapazität und $L_{par}$ der parasitären Serieninduktivität. Für eine realisierbare Dimensionierung haben elektromagnetische Feldsimulationen eine parasitäre Serieninduktivität $L_{par}$ von etwa 23 pH ergeben, so dass durch Verwendung einer Kompensations-Kapazität $C_m$ von 31 fF bei 80 GHz sich eine effektiv wirksame Kompensations-Kapazität von 37 fF ergibt.

Mit dem, was zuvor erläutert worden ist, wird also die weitere Aufgabe, die Rückwirkung der Last auf die Oszillator-Schaltung nochmals zu verringern, gelöst, und zwar dadurch, dass die Kompensations-Kapazitäten um ein bestimmtes Maß kleiner sind als die parasitären Basis-Kollektor-Kapazitäten der zu der Oszillator-Schaltung gehörenden Transistoren. Im einzelnen sind, wie das zuvor erläutert worden ist, die Kompensations-Kapazitäten so gewählt, dass die durch parasitäre Serieninduktivitäten resultierenden effektiven Kompensations-Kapazitäten im wesentlichen so groß sind wie die parasitären Basis-Kollektor-Kapazitäten der zu der Oszillator-Schaltung gehörenden Transistoren. Allgemein kann gesagt werden, dass die Kompensations-Kapazitäten etwa 10 % bis 30 %, vorzugsweise etwa 20 % kleiner sein sollten als die parasitären Basis-Kollektor-Kapazitäten der zu der Oszillator-Schaltung gehörenden Transistoren.

Im Einzelnen gibt es verschiedene Möglichkeiten, die erfindungsgemäße Schaltungsanordnung zur Erzeugung von Mikrowellen-Schwingungen bzw. die dazu gehörende Oszillator-Schaltung auszugestalten und weiterzubilden. Dazu wird auf nachfolgend beschriebene und in der Zeichnung dargestellte Ausführungsbeispiele verwiesen. In der Zeichnung zeigen

Fig. 2  ein erstes Ausführungsbeispiel einer zu einer erfindungsgemäßen Schaltungsanordnung gehörenden Oszillator-Schaltung,

Fig. 3  ein zweites Ausführungsbeispiel einer zu einer erfindungsgemäßen Schaltungsanordnung gehörenden Oszillator-Schaltung,

Fig. 4  eine Skizze zur Erläuterung der Tatsache, dass die effektive Kompensations-Kapazität von der eigentlich realisierten Kompensations-Kapazität abweicht, und

Fig. 5  eine graphische Darstellung zur Erläuterung dessen, was erfindungsgemäß erreichbar ist.

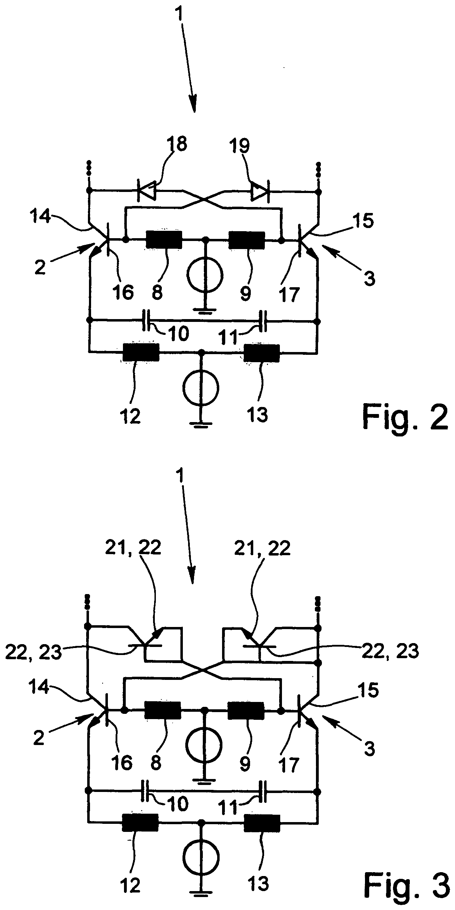

Die Fig. 2 und 3 zeigen zu Schaltungsanordnungen zur Erzeugung von Mikrowellen-Schwingungen gehörende Oszillator-Schaltungen 1.

Zu den Oszillator-Schaltungen 1 gehören jeweils zwei Verstärker-Elemente, nämlich jeweils zwei Transistoren 2 und 3, und jeweils ein Resonator 4. In den dargestellten Ausführungsbeispielen weist der Resonator 4 jeweils ein Basis-Impedanz-Netzwerk 5 und zwei Emitter-Impedanznetzwerke 6, 7 auf. Nicht dargestellt ist, daß das Basis-Impedanznetzwerk 5, ein Emitter-Impedanznetzwerk 6 oder 7, beide Emitter-Impedanznetzwerke 6 und 7 oder das Basis-Impedanznetzwerk 5 und die Emitter-Impedanznetzwerke 6 und 7 verstimmbar ist bzw. sind. Im übrigen wird zu den Oszillator-Schaltungen 1, die in den Fig. 2 und 3 dargestellt sind, auf die weiter oben gegebene Beschreibung der in Fig. 1 dargestellten Oszillator-Schaltung 1 verwiesen.

Wie die Fig. 2 und 3 zeigen, ist zwischen dem Kollektor 14 des ersten Transistors 2 und der Basis 16 des zweiten Transistors 3 sowie zwischen dem Kollektor 15 des zweiten Transistors 3 und der Basis 17 des ersten Transistors 2 jeweils eine Kompensations-Kapazität 18 bzw. 19 geschaltet.

Nicht dargestellt ist, dass die Oszillator-Schaltungen 1 Ausgangsbuffer aufweisen können, nämlich in Basisschaltung betriebene Transistoren. Nicht dargestellt ist auch, dass das angewendete Prinzip zur Verringerung der Lastrückwirkung, also zur Reduzierung des "Load-Pulling", anders ausgedrückt: zur Erzielung einer Rückwärtsisolation, also gleichsam die Kompensation der Auswirkung parasitärer Basis-Kollektor-Kapazitäten bei den zu den Oszillator-Schaltungen gehörenden Transistoren durch die beschriebenen und dargestellten Kompensations-Kapazitäten auch anderweitig bei erfindungsgemäßen Schaltungsanordnungen zur Erzeugung von Mikrowellen-Schwingungen angewendet werden können, um die Rückwärtsisolation noch weiter zu verbessern, dass beispielsweise den Oszillator-Schaltungen ein Differenzverstärker nachgeschaltet sein kann. Insoweit wird - zur Vermeidung von Wiederholungen - auf die deutsche Offenlegungsschrift 10 2008 061 254 verwiesen.

Erfindungsgemäß sind die Kompensations-Kapazitäten 18 und 19 durch gesperrte pn-Übergänge realisiert, also durch gesperrte bzw. in Sperrrichtung beanspruchte Diodenstrecken.

Im Ausführungsbeispiel nach Fig. 2 sind die Kompensations-Kapazitäten 18 und 19 als gesperrte, also in Sperrrichtung beanspruchte Dioden realisiert. Demgegenüber sind im Ausführungsbeispiel nach Fig. 3 die Kompensations-Kapazitäten 18 und 19 in gleicher Weise wie die parasitären Basis-Kollektor-Kapazitäten der zur Oszillator-Schaltung 1 gehörenden Transistoren 2 und 3 realisiert. Besonders vorteilhaft ist es, wenn als die Kompensations-Kapazitäten 18 und 19 realisierenden pn-Übergänge die pn-Übergänge von Transistoren verwirklicht sind, die mit den zu der Oszillator-Schaltung 1 gehörenden Transistoren 2 und 3 identisch sind. Das hat die Vorteile, die weiter oben bereits aufgezeigt sind.

Im Ausführungsbeispiel nach Fig. 3, bei dem die die-Kompensations-Kapazitäten 18 und 19 realisierenden gesperrten pn-Übergänge in gleicher Weise wie die parasitären Basis-Kollektor-Kapazitäten der zu der Oszillator-Schaltung 1 gehörenden Transistoren 2 und 3 realisiert sind, ist jeder Emitter 20, 21 der Transistoren, deren pn-Übergänge die Kompensations-Kapazitäten 18 und 19 realisieren, mit dessen Basis 22 bzw. 23 kurzgeschlossen.

Weiter oben ist erläutert worden, dass auch dann, wenn bei der Realisierung der erfindungsgemäßen Schaltungsanordnung ein extrem kompaktes Layout realisiert wird, sich durch die notwendige Verdrahtung parasitäre Serieninduktivitäten 24 bzw. 25 ergeben, die mit der Kompensations-Kapazität 18 bzw. 19 Serienschwingkreise 26 bzw. 27 ergeben. Unterhalb der Resonanzfrequenz der Serienschwingkreise 26 bzw. 27 führt dies zu einer vergrößerten effektiven Kapazität der Kompensations-Kapazitäten 18 und 19. Dies berücksichtigend, geht eine weitere Lehre der Erfindung, der auch für sich, losgelöst von der weiter oben erläuterten Erfindung, besondere Bedeutung zukommt, dahin, die Kapazitätswerte der Kompensations-Kapazitäten 18 und 19 um ein bestimmtes Maß kleiner zu realisieren als die Kapazitätswerte der parasitären Basis-Kollektor-Kapazitäten der zu der Oszillator-Schaltung 1 gehörenden Transistoren 2 und 3. Vorzugsweise sind die Kapazitätswerte der Kompensations-Kapazitäten 18 und 19 so gewählt, dass die durch die parasitären Serieninduktivitäten 24 und 25 resultierenden effektiven Kapazitätswerte der Kompensations-Kapazitäten 18 und 19 im wesentlichen so groß sind wie die Kapazitätswerte der parasitären Basis-Kollektor-Kapazitäten der zu der Oszillator-Schaltung 1 gehörenden Transistoren 2 und 3. Um welches Maß die Kapazitätswerte der Kompensations-Kapazitäten 18 und 19 kleiner sein sollen als die Kapazitätswerte der parasitären Basis-Kollektor-Kapazitäten der zu der Oszillator-Schaltung 1 gehörenden Transistoren 2 und 3, lässt sich durch elektromagnetische Feldsimulationen bestimmen. In der Regel kommt man dann zu Kapazitätswerten der Kompensations-Kapazitäten 18 und 19, die um etwa 10 % bis 30 %, vorzugsweise um etwa 20 %, kleiner sind als die Kapazitätswerte der parasitären Basis-Kollektor-Kapazitäten der Transistoren 2 und 3, die zu der Oszillator-Schaltung 1 gehören.

Die Realisierung dessen, was zuvor erläutert worden ist, kann in einer integrierten Schaltung durch eine Skalierung der Transistorgröße erfolgen. Haben z. B. die zu der Oszillator-Schaltung 1 gehörenden Transistoren 2 und 3 jeweils eine Emitterfläche von $A_E = 2$ x $0,35 \, \mu m$ x $10 \, \mu m$, so kann für die der Realisierung der Kompensations-Kapazitäten 18 und 19 dienenden Transistoren eine Emitterfläche von $A_E = 2$ x $0,35 \, \mu m$ x $8,2 \, \mu m$ realisiert werden. Dazu ist darauf hinzuweisen, dass bei einem geschichteten Aufbau von Bipolartransistoren die Fläche der Basis-Emitter-Grenzschicht identisch ist zu der Fläche der Kollektor-Basis-Grenzschicht.

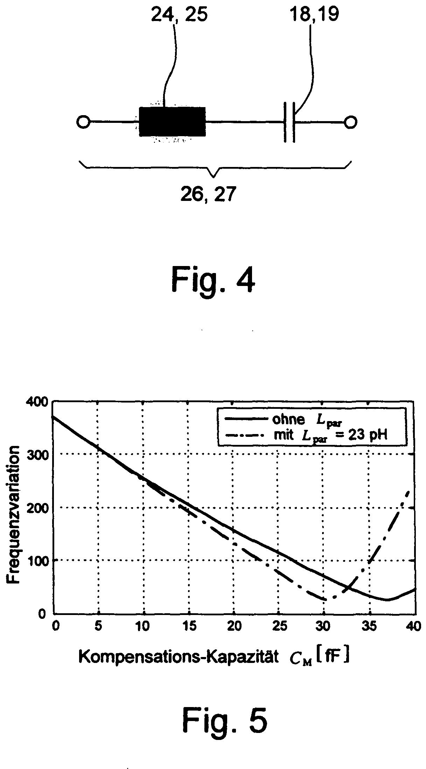

In der Fig. 5 ist die Wirksamkeit der Kompensation in Abhängigkeit des Kapazitätswertes der Kompensations-Kapazitäten 18 und 19 dargestellt. Es ergibt sich eine erhebliche Reduzierung der Lastrückwirkung. Durch die Berücksichtigung der parasitären Serieninduktivitäten 24 und 25 verschiebt sich das Optimum weiter nach links, und es wird noch schmaler, so dass die Schaltungsanordnung noch empfindlicher auf Fertigungstoleranzen, Temperaturänderungen und Arbeitspunktverschiebungen reagiert.

Im Einzelnen zeigt die Fig. 5 die Simulation der Frequenzvariation (frequency pulling $\delta f_{FP}$) durch eine fehlangepasste Last (- 12 dB) in Abhängigkeit von der Kompensations-Kapazität $C_M$, einerseits mit, andererseits ohne die parasitäre Serieninduktivität $L_{par}$, wobei von einer parasitären Serieninduktivität $L_{par}$ von etwa 23 pH ausgegangen worden ist

**Patentansprüche**

1. Verfahren zur Bestimmung von Kapazitätswerten für Kompensations-Kapazitäten in einer Schaltungsanordnung zur Erzeugung von Mikrowellen-Schwingungen, mit einer Oszillator-Schaltung (1) mit zwei Transistoren (2, 3) und mit einem ein Basis-Impedanznetzwerk (5) und zwei Emitter-Impedanznetzwerke (6, 7) umfassenden Resonator (4), wobei das Basis-Impedanznetzwerk (5) oder/und ein Emitter-Impedanznetzwerk (6, 7) oder beide Emitter-Impedanznetzwerke (6, 7) verstimmbar ist bzw. sind, wobei die Transistoren (2, 3) jeweils eine parasitäre Basis-Kollektor-Kapazität aufweisen und wobei zwischen dem Kollektor (14) des ersten Transistors (2) und der Basis (17) des zweiten Transistors (3) sowie zwischen dem Kollektor (15) des zweiten Transistors

(3) und der Basis (16) des ersten Transistors (2) jeweils eine Kompensations-Kapazität (18, 19) geschaltet ist,

**dadurch gekennzeichnet,**

**dass** durch elektromagnetische Feldsimulationen parasitäre Serieninduktivitäten (24, 25) einer Verdrahtung bestimmt werden, dass die Kapazitätswerte der Kompensations-Kapazitäten (18, 19) um ein bestimmtes Maß kleiner als die Kapazitätswerte der parasitären Basis-Kollektor-Kapazitäten der zu der Oszillator-Schaltung (1) gehörenden Transistoren (2, 3) mit der Maßgabe bestimmt werden, dass die durch die parasitäre Serieninduktivitäten (24, 25) resultierenden effektiven Kapazitätswerte der Kompensations-Kapazitäten (18, 19) so groß sind wie die Kapazitätswerte der parasitären Basis-Kollektor-Kapazitäten der zu der Oszillator-Schaltung (1) gehörenden Transistoren (2, 3).

## Claims

1. Method for determining capacitance values for compensation capacitances of a circuit arrangement for generating microwave oscillations, having an oscillator circuit (1) with two transistors (2, 3) and having a resonator (4) comprising a base impedance network (5) and two emitter impedance networks (6, 7), wherein the base impedance network (5) or/and one emitter impedance network (6, 7) or both emitter impedance networks (6, 7) is/are tunable, wherein the transistors (2, 3) each have a parasitic base collector capacitance and wherein a respective compensation capacitance (18, 19) is connected between the collector (14) of the first transistor (2) and the base (17) of the second transistor (3) and between the collector (15) of the second transistor (3) and the base (16) of the first transistor (2),

**characterized in**

**that** parasitic series inductances (24, 25) of a wiring are determined by electromagnetic field simulations, that the capacitance values of the compensation capacitances (18, 19) are smaller by a specific amount than the capacitance values of the parasitic base collector capacitances of the transistors (2, 3) which belong to the oscillator circuit (1), providing that the effective capacitance values of the compensation capacitances (18, 19) resulting from the parasitic series inductances (24, 25) are as large as the capacitance values of the parasitic base collector capacitances of the transistors (2, 3) belonging to the oscillator circuit (1).

## Revendications

1. Procédé de détermination de valeurs de capacité pour des capacités de compensation dans un système de circuit destiné à générer des oscillations micro-ondes, comportant un circuit oscillateur (1) muni de deux transistors (2, 3) et comportant un résonateur (4) comprenant un réseau d'impédances de base (5) et deux réseaux d'impédances d'émetteur (6, 7), dans lequel le réseau d'impédances de base (5) et/ou un réseau d'impédances d'émetteur (6, 7) ou les deux réseaux d'impédances d'émetteur (6, 7) sont ou peuvent être accordés, dans lequel les transistors (2, 3) présentent chacun une capacité de collecteur de base parasite et dans lequel une capacité de compensation respective (18, 19) est connectée entre le collecteur (14) du premier transistor (2) et la base (17) du deuxième transistor (3) et entre le collecteur (15) du deuxième transistor (3) et la base (16) du premier transistor (2),

**caractérisé en ce que** des inductances série parasites (24, 25) d'un câblage sont déterminées par des simulations de champ électromagnétique, **en ce que** les valeurs de capacité des capacités de compensation (18, 19) sont déterminées comme étant inférieures d'une quantité déterminée aux valeurs de capacité des capacités base-collecteur parasites des transistors (2, 3) appartenant au circuit oscillateur (1) sous réserve que les valeurs de capacité effectives des capacités de compensation (18, 19) résultant des inductances série parasites (24, 25) soient aussi élevées que les valeurs de capacité des capacités base-collecteur parasites des transistors (2, 3) appartenant au circuit oscillateur (1).

Fig. 1

Fig. 2

Fig. 3

Fig. 4

Kompensations-Kapazität $C_M$ [fF]

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008061254

**In der Beschreibung aufgeführte Nicht-Patentliteratur**

- **S. NICOLSON et al.** Design and Scaling of W-Band SiGe BiCMOS VCOs. *IEEE Journal of Solid-State Circuits,* September 2007, vol. 42 (9
- **ULRICH TIETZE ; CHRISTOPH SCHENK.** Halbleiter-Schaltungstechnik. Springer-Verlag
- Dependence of the input impedance of a three-electrode vacuum tube upon the load in the plate cirsuit. *Scientific Papers of the Bureau of Standards,* 1920, vol. 15 (351), 367-385
- Fully Integrated SiGe VCOs With Powerful Output Buffer for 77-GHz Automotive Radar Systems and Applications Around 100 GHz. *IEEE Journal of solid-state circuits,* Oktober 2004, vol. 39 (10